# EUROPEAN PATENT SPECIFICATION

(11) **EP 0 654 813 B1**
(45) Date of publication and mention of the grant of the patent: **10.03.1999**
(21) Application number: 94114545.0
(22) Date of filing: 15.09.1994
(51) Int. Cl.: H01J 37/20, H01J 37/317

(54) **Electron beam drawing apparatus and method of drawing with such an apparatus**
Gerät zur Musteraufzeichnung mittels Elektronenstrahl und Mustersaufzeichnungsverfahren unter Verwendung eines solchen Geräts
Appareil de traçage de motifs par faisceau d'électrons et méthode de traçage de motifs utilisant un tel appareil

(30) Priority: 28.10.1993 JP 270992/93
(43) Date of publication of application: 24.05.1995
(73) Proprietor: MITSUBISHI DENKI KABUSHIKI KAISHA, Tokyo 100 (JP)
(72) Inventor: Moriizumi, Koichi, c/o Mitsubishi Denki K.K., Itami-shi, Hyogo 664 (JP); Kamiyama, Kinya, c/o Mitsubishi Denki K.K., Itami-shi, Hyogo 664 (JP); Taoka, Hironobu, c/o Mitsubishi Denki K.K., Itami-shi, Hyogo 664 (JP)
(74) Representative: Prüfer, Lutz H., Dipl.-Phys.

(56) References cited:
- EP-A- 0 422 655
- US-A- 4 516 029
- US-A- 4 627 009
- US-A- 5 175 435
- PATENT ABSTRACTS OF JAPAN vol. 10, no. 236 (E-428) 15 August 1986 & JP-A-61 067 914 (SONY) 8 April 1986
- PATENT ABSTRACTS OF JAPAN vol. 12, no. 498 (E-698) 24 December 1988 & JP-A-63 209 127 (NEC CO.) 30 August 1988
- PATENT ABSTRACTS OF JAPAN vol. 10, no. 236 (E-428) 15 August 1986 & JP-A-61 067 912 (SONY) 8 April 1986
- J. VAC. SCI. TECHNOL., vol.B10, no.6, NOV/DEC 92, page 2759 - 2763, Y. SAKITANI ET AL. 'ELECTRON-BEAM CELL-PROJECTION LITHOGRAPHY SYSTEM'
- "Microwave Engineering", A.N. BROERS AND T.H.P. CHANG, HIGH RESOLUTION LITHOGRAPHY, Fig. 18, Cambridge University Press, 1979, edited by H. Armed and T.H.P. Chang.
- J. VAC. SCI. TECHNOL., vol.B5, no.1, JAN/FEB 87, page 70 - 74, R. YOSHIKAWA ET AL. 'A HIGH DOSE AND HIGH ACCURACY VARIABLE SHAPED ELECTRON BEAM EXPOSURE SYSTEM FOR QUARTERMICRON DEVICE FABRICATION'

## Description

The present invention relates to an electron beam drawing apparatus according to the preamble of claim 1 and a method of drawing with an electron beam drawing apparatus according to the preamble of claim 6. More specifically, the invention improves the structure of an electron beam drawing apparatus of variable formation type and a method of drawing with such an apparatus.

An electron beam exposure apparatus and method according to the preambles of claims 1 and 6 is known from US 5 175 435.

Today, prevailing among electron beam exposure apparatuses are electron beam drawing apparatuses of variable formation type which permit high speed drawing. Particularly in the field of electron beam drawing intended to directly form LSI patterns with electron beams, drawing by means of variable formation method is most popular. Electron beam drawing apparatuses employing variable formation methods for producing photomasks or X ray masks for semiconductor process are also paid much attention.

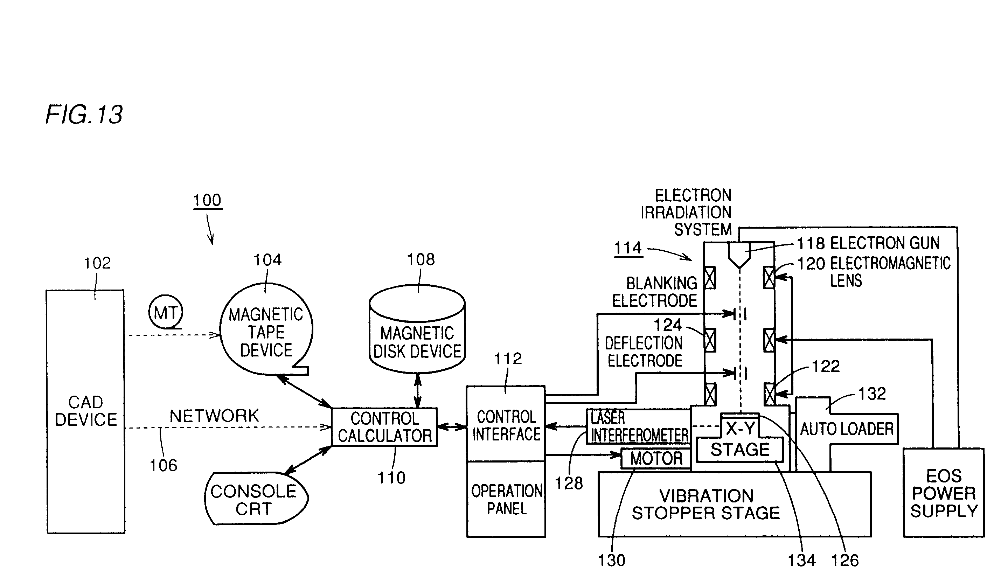

Now, the structure of such an electron beam drawing apparatus will be described in conjunction with Fig. 13.

In electron beam drawing apparatus 100, pattern data produced with a CAD machine 102 for example is transferred to a magnetic disk device 108 from a control calculator 110 through a magnetic tape device 104 or a network 106. Then, the pattern data is read from magnetic disk device 108 into control calculator 110 in which control signals for determining the size, position, and time of irradiation of an electron beam are calculated, and these signals are transferred to an electron irradiation system 114 through a control interface 112.

Based on the pattern data, an electron beam irradiated from an electron gun 118 is converged by electromagnetic lenses 120 and 122. The converged electron beam forms an image on a substrate 126 to be drawn on an X-Y stage 134. The electron beam is deflected according to the pattern data, and turned on/off, and a prescribed pattern is thus drawn on substrate 126.

Meanwhile, since the range of deflection of an electron beam is small, substrate 126 is moved in the X and Y directions by X-Y stage 134, in order to subject the entire surface of substrate 126 to drawing. The position of X-Y stage 134 is always measured with a laser interferometer 128, an error from a set value is fed back to a drive motor 130 and a deflection electrode 124, and the electron beam is accurately positioned. Note that an auto loader 132 is placed in the vicinity of X-Y stage 134, and automatically leads in and out substrate 126 for continuous drawing.

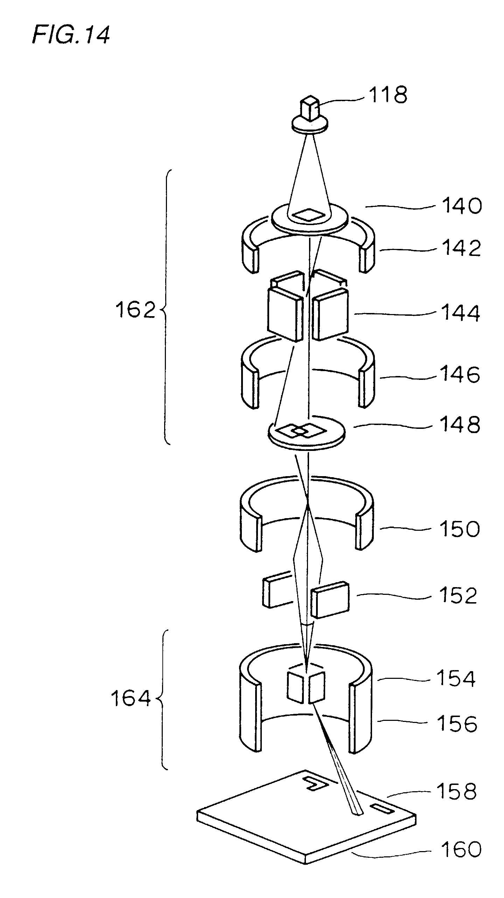

Now, the structure of electron irradiation system 114 will be described in conjunction with Fig. 14.

Provided in electron irradiation system 114 are an electron gun 118, a first formation diaphragm 140, a first formation lens 142, a formation scanner 144, a second formation lens 146, a second formation diaphragm 148, a reduction lens 150, a blanking electrode 152, a scanner 154, and a convergent lens 156, with an exposure pattern 158, and a workpiece 160 being placed below. First formation diaphragm 140, first formation lens 142, formation scanner 144, second formation lens 146 and second formation diaphragm 148 constitute a variable formation lens portion 162. Scanner 154 and convergent lens 156 constitute a convergent scan lens portion 164.

In electron irradiation system 114 of variable formation method, using first formation diaphragm 140 and second formation diaphragm 148 having rectangular openings, a rectangular electron beam passed through first formation diaphragm 140 is cut into a necessary size at second formation diaphragm 148, and a rectangular electron beam of a desired size necessary for LSI pattern formation is formed. The rectangular electron beam is deflected with electrostatic or electromagnetic scanner 154 and irradiates a desired position of workpiece 160.

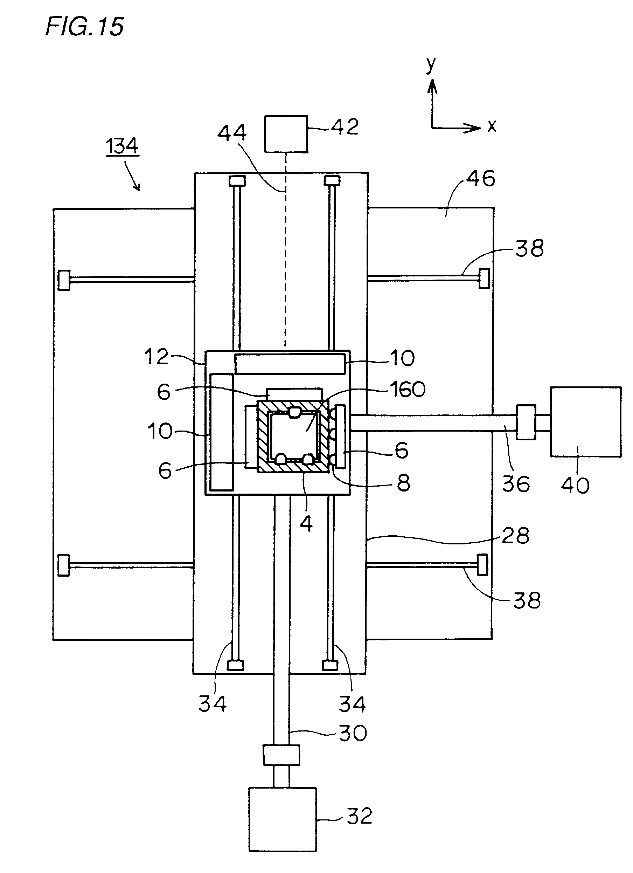

The structure of X-Y stage 134 for positioning of installed workpiece 160 will be described in conjunction with Fig. 15. A X-Y stage similar to that shown in Fig. 15 is disclosed in Y. Sakitani et al, "Electron - beam cell-projection lithography system", J. Vac. Sci. Technol. B 10(6), Nov/Dec 1992, p. 2762.

Workpiece 160 is mounted by a workpiece holder 4 on a stage 12 for Y-direction movement movable in the Y-direction. Workpiece holder 4 is fixed on Y-direction movement stage 12 with workpiece holder fixing metal fittings 6 and a workpiece holder fixing spring 8. Mirrors 10, 10 for measuring the position of Y-direction movement stage 12 are placed on Y-direction movement stage 12. Mirrors 10, 10 have vertical planes opposite to workpiece holder 4 functioning as reflection surfaces.

Y-direction movement stage 12 is provided movably on a pair of Y-direction rails 34, 34 provided on an X-direction movement stage 28. X-direction movement stage 28 is movably provided on a pair of X-direction rails 38, 38 provided on a base 46.

Y-direction movement stage 12 is provided with a drive shaft 38 for moving Y-direction movement stage 12 in the Y-direction and a motor 32. X-direction movement stage 28 is provided with a drive shaft 36 for moving X-direction movement stage 28 in the X-direction and a motor 40.

For positional control of workpiece 160, a laser beam 44 is emitted upon mirror 10 fixed at Y-direction movement stage 12 with a laser interferometer 42 for positional measurement, and the position is measured taking advantage of optical interference between a reflected laser beam and the emitted laser beam. The positional measurement in the X-direction is similarly conducted.

According to such a variable formation method using an electron beam drawing apparatus as described above, referring to Figs. 16 and 17, high speed drawing is enabled by shot-dividing drawing data 170, 172 into a prescribed size (4µm x 4µm, for example) (178) and irradiating only a necessary portion with an electron beam, unlike the case of a raster scan by which drawing data 170, 172 is developed onto a bit map 174 and drawing is conducted by scanning almost the entire surface of a workpiece while repeatedly turning on/off the beam. A similar variable formation method is disclosed in "Microcircuit Engineering", A.N. BROERS AND T.H.P. CHANG, HIGH RESOLUTION LITHOGRAPHY, Fig. 18, Cambridge University Press, 1979, edited by H. Armed and T.H.P. Chang.

It is established that as a method of correcting the proximity effect, a major problem associated with drawing with an electron beam, a method of dividing an LSI pattern into small portions and adjusting the amount of electron beam irradiation for application at the time of drawing each divided figure is the most effective method. According to the above-described raster scan method, the amount of exposure light cannot be modulated for its constant scanning rate, while according to the variable formation method, a considerably large tonal range (such as 64 tones) is permitted and the amount of electron beam irradiation can readily be modulated. Also in this point, the variable formation method is superior to the raster scan method, and an electron beam drawing apparatus according to such a variable formation method is particularly preferable for a very small LSI pattern with significant proximity effect.

Meanwhile, most figures constituting LSI patterns are rectangular, and therefore an electron beam drawing apparatus according to the variable formation method capable of readily forming a rectangular electron beam has not been encountered with any problem. However, to cope with recent integration levels of LSIs, figures rotated at prescribed rotating angles (hereinafter referred to as rotated figures) came to be used, particularly for memory devices.

Since rotated figures at a rotating angle of 45°C came to be used more often in a memory cell, rotated figures at the rotating angle of 45° sometimes account for about 80% of the total figures. The electron beam drawing apparatus of the variable formation type described above cannot draw a rotated figure with the rotating angle of 45° by a single irradiation, drawing of such a rotated figure at the rotating angle of 45° is conducted by approximating such a figure with an elongate rectangular electron beam.

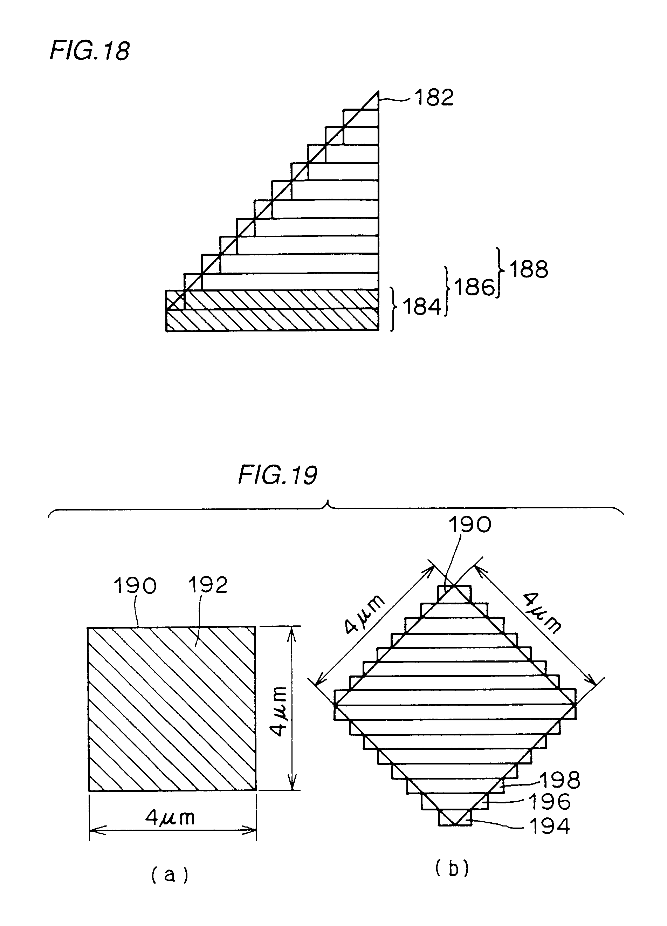

A method of such approximation will be described in conjunction with Fig. 18.

According to this method, a triangle 16 is drawn sequentially with rectangular beams 184, 186, and 188. The length of a shorter side of a rectangular beam according to the approximation method which depends on the precision of an LSI pattern to be formed is usually about in the range from 0.1µm to 0.5µm. Although adjacent rectangular beams are overlapped by 1/2 as illustrated in Fig. 18, drawing without such overlapping may be employed. According to this approximation method, a shorter side of a rectangular beam is reduced enough such that further adjacent rectangles are overlapped, a highly precise figure pattern rotated at a rotating angle of 45° results. In order to imprcve the precision, however, the number of shots for drawing one rotated figure increases. For example, referring to Fig. 19 at (a) and (b), for a maximum exposure beam size of 4µm□, a square with a rotating angle of 0° is formed only by a single shot, while a square with a rotating angle of 45° requires about 16 times as many shots if the approximation method with a shorter side of 0.5µm is employed without overlapping. Accordingly, a long period of time is required for drawing an LSI including a large number of rotated figures. The precision of the drawn inclined side is lower than the sides of a figure which is not rotated.

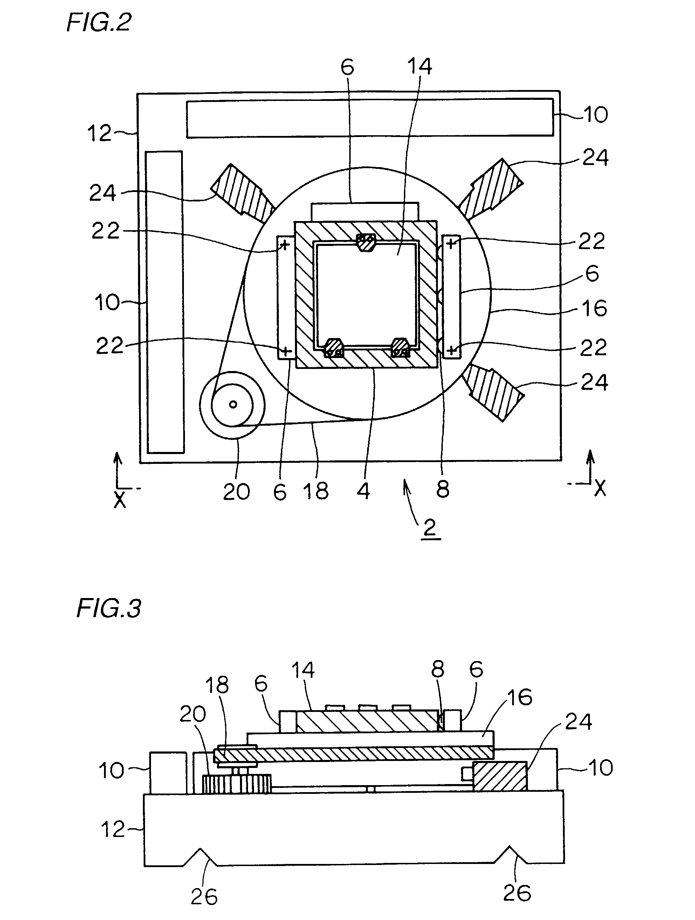

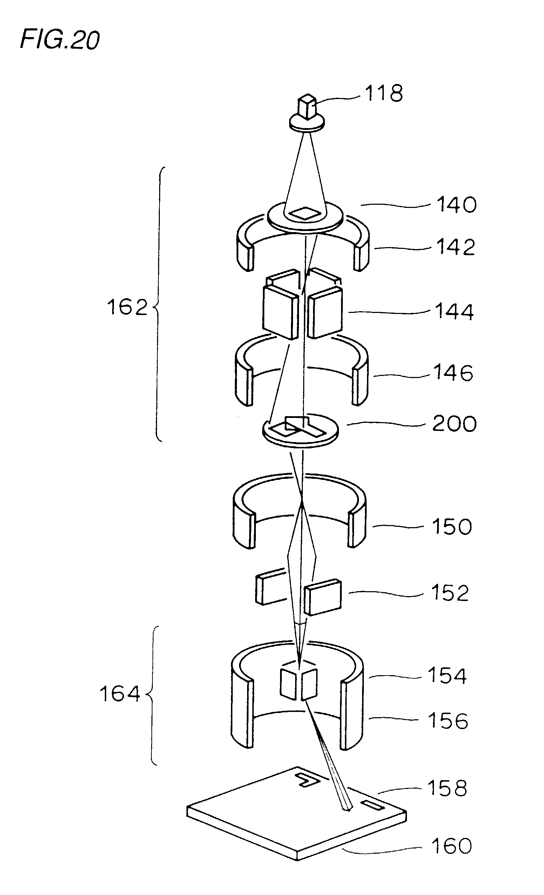

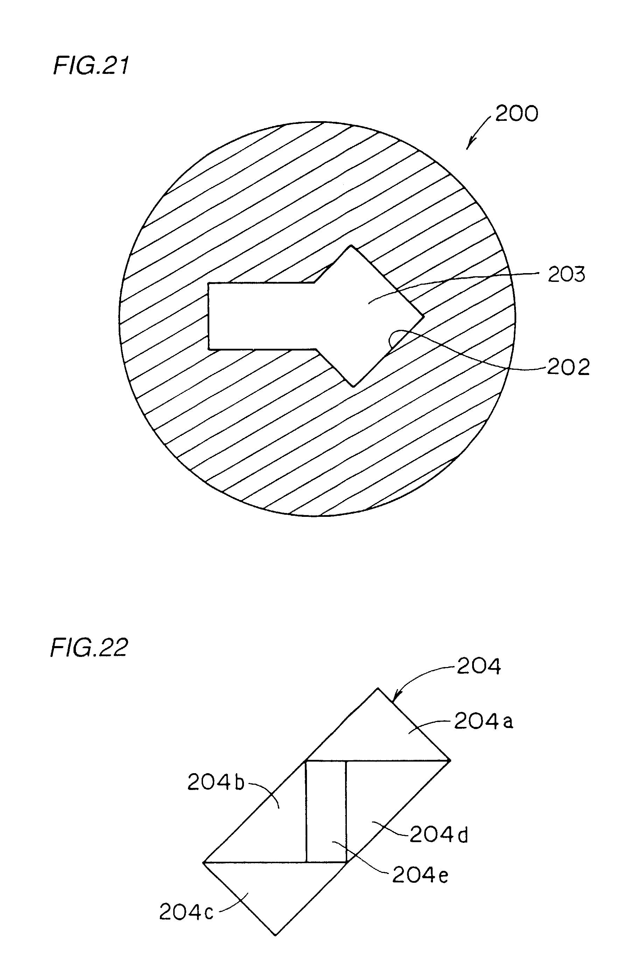

An electron beam drawing apparatus of a variable formation type which has solved the above-described problems will be described in conjunction with Figs. 20 and 21. A similar apparatus is disclosed in R. Yoshikawa et al, "A high dose and high accuracy variable shaped electron beam exposure system for quarter micron device fabrication", J. Vac. Sci. Technol. B 5(1), Jan/Feb 1987, Fig. 2.

Referring to Fig. 20, the electron beam drawing apparatus has a second formation diaphragm 200 with an opening having sides forming prescribed rotating angles. The other structure of the apparatus is substantially identical to the electron beam drawing apparatus shown in Fig. 14.

The structure of second formation diaphragm 200 will be described in conjunction with Fig. 21. Second formation diaphragm 200 has an opening 203 with an inclined side 202 at 45°. Using second formation diaphragm 200 having such an opening, a rectangle 204 rotated by 45° as illustrated in Fig. 22, for example, can be drawn by five exposure steps if the rectangle is divided into five areas 204a, 204b, 204c, 204d, and 204e. Accordingly, the number of figures and time required for drawing can be reduced with respect to the approximation method as illustrated in Fig. 18 and 19.

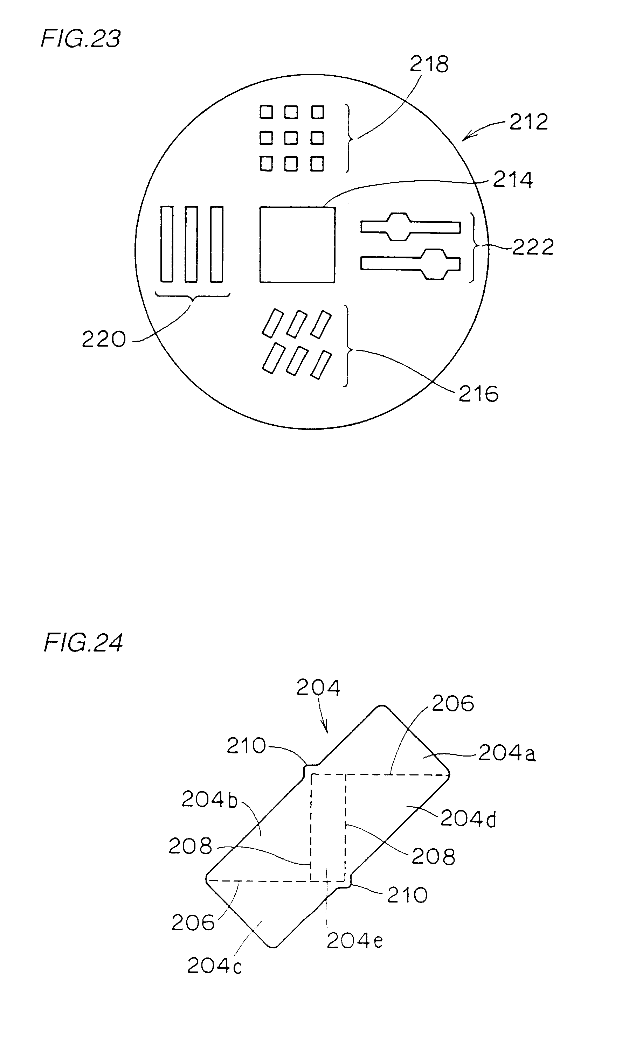

As a method of greatly reducing time required for drawing by means of electron beam exposure, the cell projection method has been developed. According to the method, when groups of identical figures as those in a memory device are placed at certain intervals in a large number, the groups of figures are all formed at the second formation diaphragm used in the variable formation type electron beam drawing apparatus, and in the case of a memory cell portion, for example, the plurality of groups of figures are drawn by one shot at a time. One example of such a second formation diaphragm used according to this method is illustrated in Fig. 23.

Referring to Fig. 23, second formation diaphragm 212 used according to this method is provided with five kinds of openings, a rectangular beam size determination opening portion 214, a memory cell pattern opening portion 216 for element isolation, a memory cell pattern opening portion 218 for contact hole, a memory cell pattern opening portion 220 for gate electrode, and a memory cell pattern opening portion 222 for interconnection. Thus, patterns formed by about 100 shots in a usual variable formation type electron beam drawing apparatus can be included. The resulting number of shots is not simply reduced to 1/100 or smaller in practice considering necessary patterns for peripheral circuitry other than the memory cell, but time required for drawing a device having a large number of identical figures placed at certain intervals such as a memory device can be greatly reduced.

The electron beam drawing apparatus according to the cell projection method described above is however encountered with the following problems.

The most significant problem is its very small flexibility in terms of changes in sizes of figures, and angles. This means that all possible angles and sizes expected to be used must be prepared for the second formation diaphragm before forming the second formation diaphragm, and the prepared angles and sizes cannot be changed once the second formation diaphragm is formed, except by remanufacturing the second formation diaphragm.

Such a second formation diaphragm cannot be readily produced, and more than several days is necessary even using highly advanced semiconductor process techniques. Therefore, in terms of high speed drawing, the cell projection method described above can be efficiently used for the manufacture of LSI devices which are unlikely to be changed in design in the future and planned for mass production, but for patterns to be frequently revised due to changes of designs, for example, when a prototype device is developed through various developments and researches and a large number of such second formation diaphragms must be produced, the cost associated with the research and development increases.

The method using the second formation diaphragm having an inclined side as illustrated in Fig. 21 provides higher flexibility in terms of the size of figures than the cell projection method, but is still encountered with the following problem.

When a pattern as shown in Fig. 22 is drawn, a so-called edge roughness 210 is produced at a joint of figures in a resist pattern drawn with a triangular beam and a rectangular beam and developed, and such a resist pattern is extremely poor in precision. This is caused even by a small mistake in adjustment of the rectangular beam.

It is an object of the invention to provide an electron beam drawing apparatus capable of drawing at a high speed rectangles with an arbitrary rotating angle which can be used in the next generation memory devices and with a high precision, and a method of drawing with such an apparatus.

This object is achieved by an apparatus according to claim 1 and a method according to claim 6.

The invention provides an electron beam drawing apparatus providing high flexibility in terms of rotating angles and sizes of figures and capable of minimizing the amount of drawing data, and a method of drawing with such an apparatus.

Further improvements of the invention are given in the subclaims.

In an electron beam drawing apparatus according to an embodiment of the invention, the workpiece installment device includes a third stage rotatable within the drawing plane as the rotating device. Preferably, the second stage is provided on the first stage, and the third stage is provided on the second stage.

More preferably, a rotating angle detection device for detecting the rotating angle of the third stage is provided at a prescribed position of the third stage.

In an electron beam drawing apparatus according to another embodiment of the invention, the beam formation device includes said rotating device for rotating the beam formation mask in a plane parallel to the drawing plane.

The workpiece installment device and the beam formation device can be relatively rotated so that the workpiece is irradiated with the exposure beam formed into the prescribed shape, and a first pattern having a first rotating angle and a second pattern having a second rotating angle are drawn on the workpiece.

With the electron beam drawing apparatus, an arbitrary rotating angle is made possible between the beam formation device and the workpiece installment device. As a result, patterns having rotating angles based on the rotating angles can be readily and precisely drawn on the workpiece by a single exposure.

In a method of drawing with an electron beam drawing apparatus according to an embodiment of the invention a plurality of patterns having prescribed angles are drawn on the workpiece. In addition, in the step of drawing the plurality of prescribed patterns on the workpiece, patterns having identical rotating angles are grouped, and the patterns are drawn on a group basis.

Thus, time for making prescribed rotating angles to the beam formation device and the workpiece installment device and time for measuring the rotating angles are reduced, and so-called overhead time can be reduced.

The foregoing and other objects, features, aspects and advantages of the present invention will become more apparent from the following detailed description of the present invention when taken in conjunction with the accompanying drawings. The drawings show:

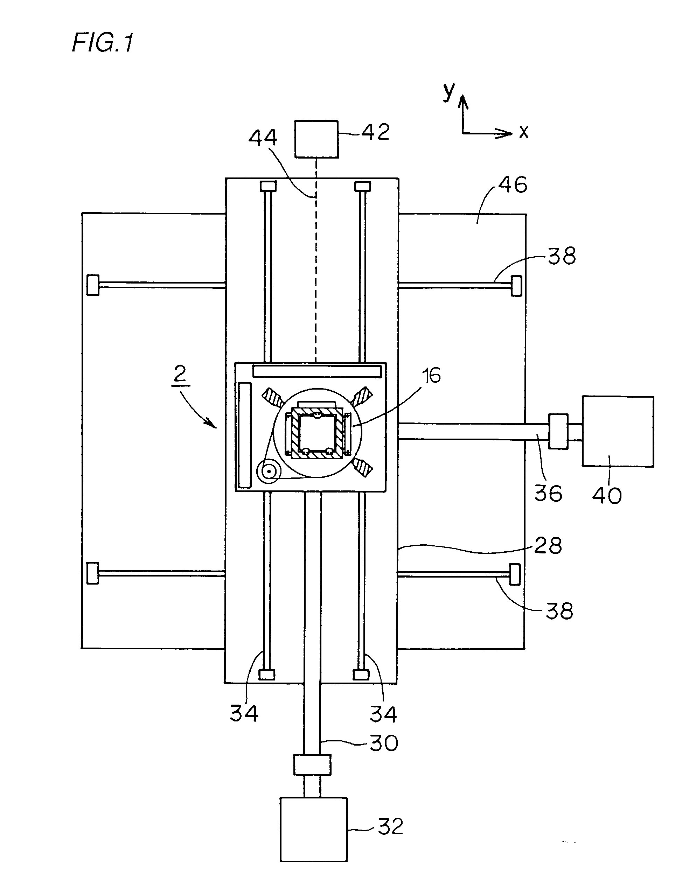

Fig. 1 is a plan view showing an X-Y stage in an electron beam drawing apparatus according to a first embodiment of the invention;
Fig. 2 is a plan view showing a Y-direction movement stage used in the first embodiment of the invention;
Fig. 3 is a view showing the Y-direction movement stage as viewed in the direction of the arrows X;

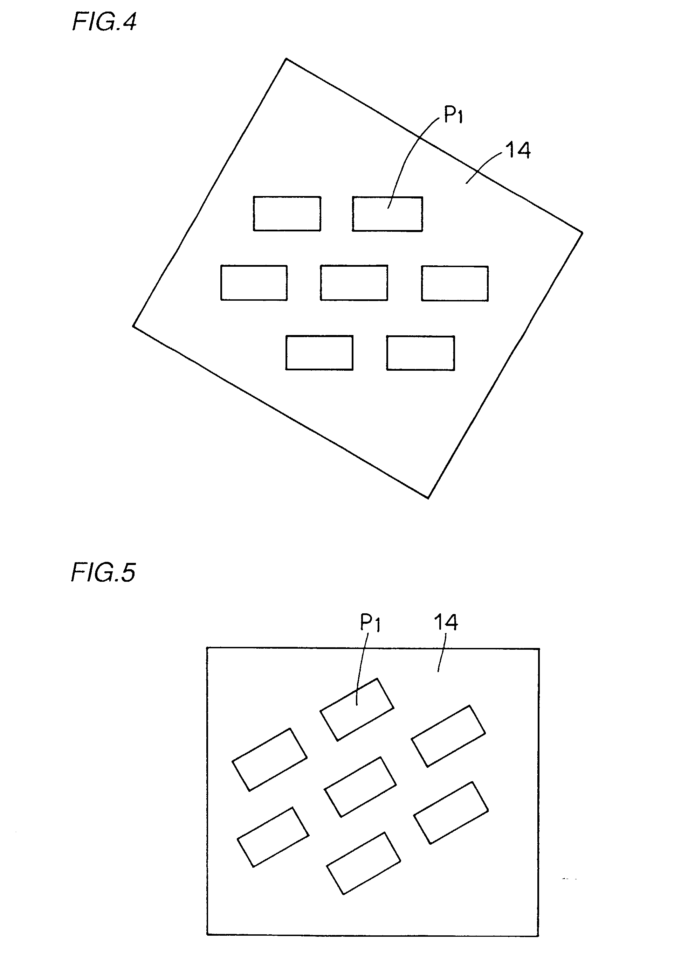

Fig. 4 is a view showing patterns to be drawn according to the first embodiment of the invention;
Fig. 5 is a view showing patterns to be drawn according to a conventional technique;

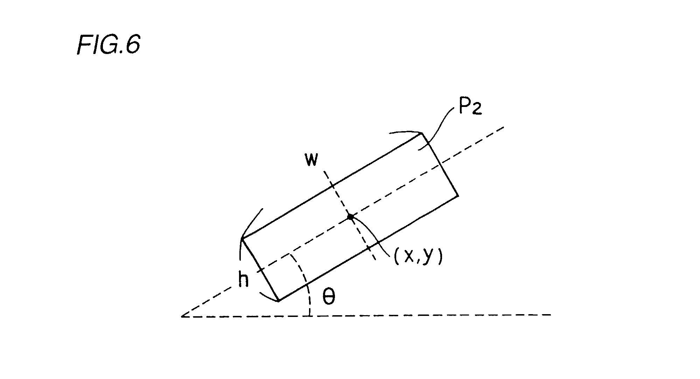

Fig. 6 is a representation showing a rotating angle for a drawing pattern;

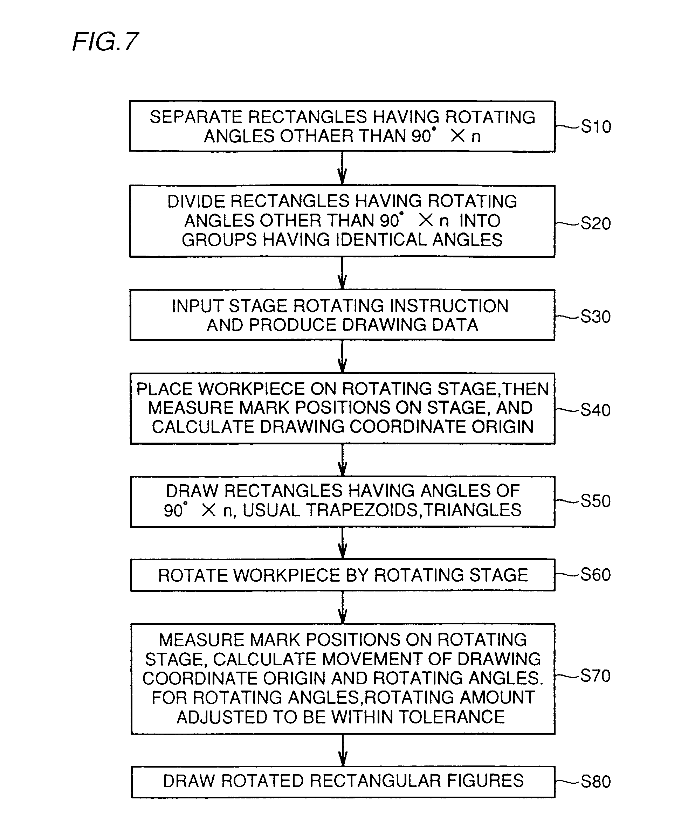

Fig. 7 is a flow chart for use in illustration of a method of drawing with the electron beam drawing apparatus according to the first embodiment of the invention;

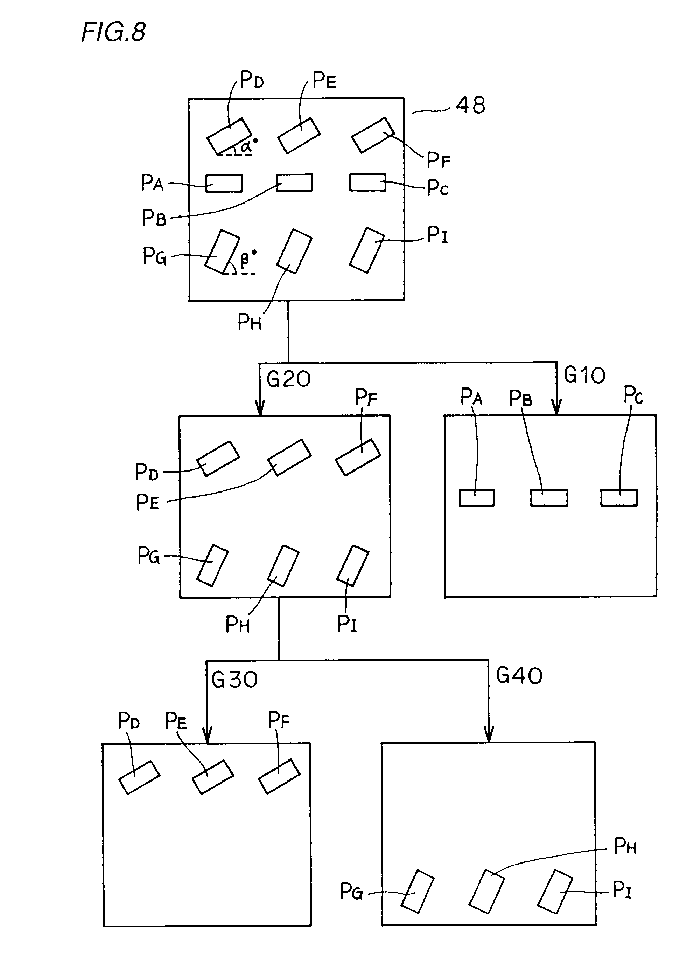

Fig. 8 is a representation showing how patterns are divided into groups in a method of drawing with the electron beam drawing apparatus according to the first embodiment of the invention;

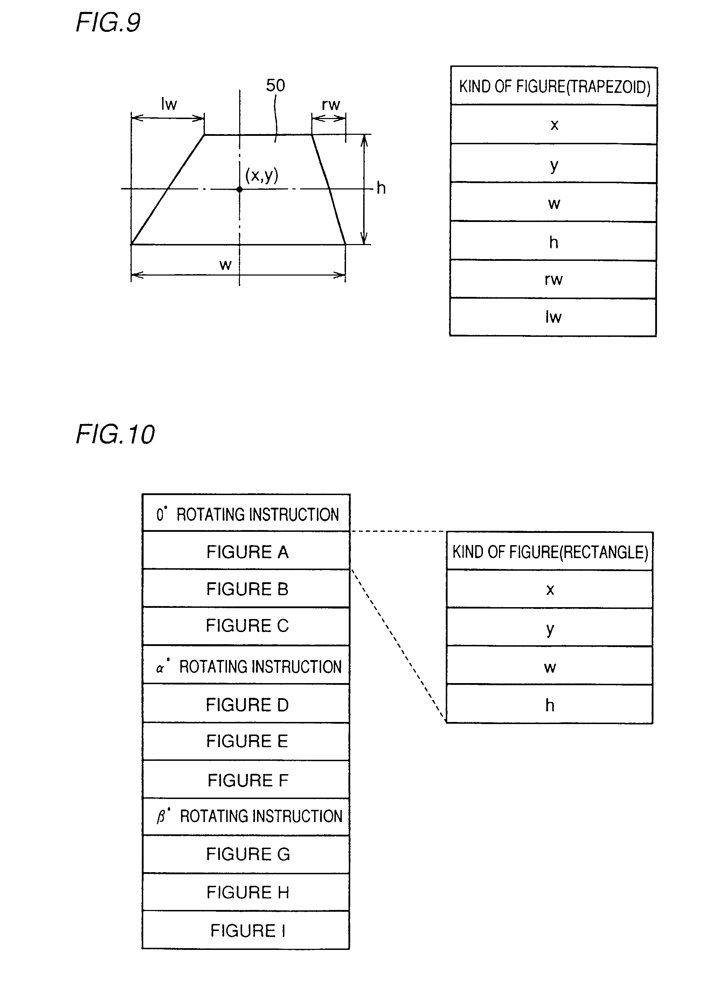

Fig. 9 is a representation showing an effect brought about by a method of drawing with the electron beam drawing apparatus according to the first embodiment of the invention;
Fig. 10 is a representation showing an effect brought about by a method of drawing with the electron beam drawing apparatus according to the first embodiment of the invention;

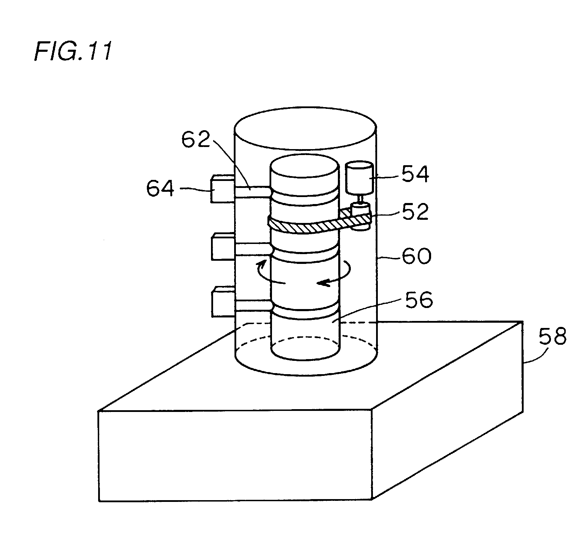

Fig. 11 is a perspective view showing the structure of an electron beam drawing apparatus according to a second embodiment of the invention;

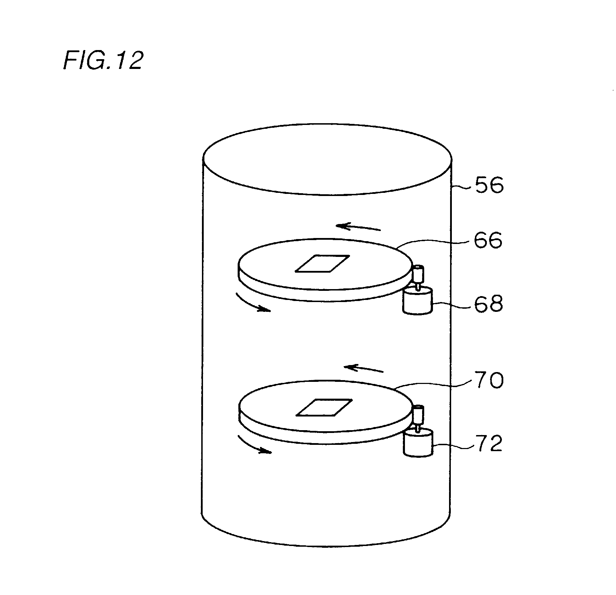

Fig. 12 is a perspective view showing the structure of an electron beam drawing apparatus according to a third embodiment of the invention;
Fig. 13 is a block diagram showing the structure of an electron beam drawing apparatus;
Fig. 14 is a view showing the construction of an electron irradiation system in an electron beam drawing apparatus according to a conventional technique;
Fig. 15 is a plan view showing the structure of an X-Y stage according to a conventional technique;

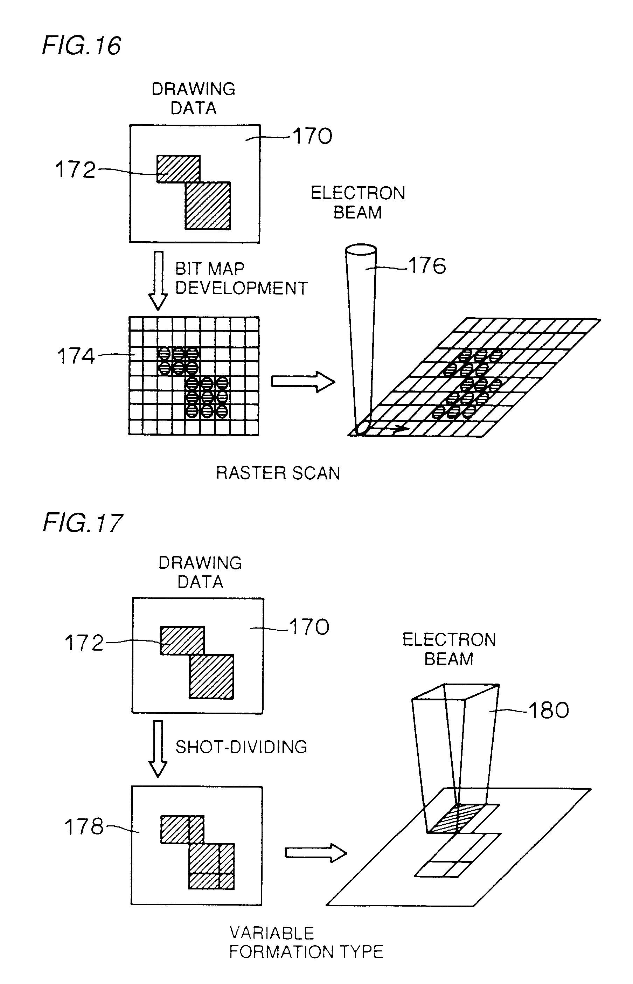

Fig. 16 is a view for use in illustration of a method of electron beam drawing according to a conventional raster scan system;
Fig. 17 is a view for use in illustration of a conventional method of electron beam drawing of variable formation type;
Fig. 18 is a view for use in illustration of a conventional method of electron beam drawing;
Fig. 19 is a view for use in illustration of a conventional method of electron beam drawing;
Fig. 20 is another view for use in illustration of a conventional raster scan system in an electron irradiation system;
Fig. 21 is a plan view showing a second formation diaphragm used in Fig. 20;
Fig. 22 is a view showing the structure of a drawing pattern according to the raster scan system;
Fig. 23 is a view showing a variation of the raster scan system; and
Fig. 24 is a plan view for use in illustration of problems associated with a conventional technique.

### DESCRIPTION OF THE PREFERRED EMBODIMENTS

A first embodiment of the invention will be described in conjunction with the accompanying drawings. Note that the structure of an electron beam drawing apparatus according to this embodiment is substantially identical to the structure described in conjunction with Figs. 13 and 14, and therefore a detailed description thereof is not provided here, and only the structure of an X-Y stage which is characteristic of this embodiment will be described.

Referring to Fig. 1, a Y-direction movement stage 2 is provided on an X-direction movement stage 28. Y-direction movement stage 2 is provided movably on a pair of Y-direction rails 34, 34 provided on X-direction movement stage 28. X-direction movement stage 28 is provided movably on a pair of X-direction rails 38, 38 provided on a base 46.

Y-direction movement stage 2 is provided with a drive shaft 30 and a motor 32 for moving Y-direction movement stage 2 in the Y-direction. X-direction movement stage 28 is provided with a drive shaft 36 and a motor 40 for moving X-direction movement stage 28 in the X-direction.

The structure of Y-direction movement stage 2 will be described in detail in conjunction with Figs 2 and 3. A workpiece rotating stage 16 is provided on a moving stage 12. Rotating stage 16 is rotatable by a driving motor 20 with a stage rotating belt 18.

A workpiece 14 is fixed on workpiece rotating stage 16 with a workpiece holder 4. Workpiece holder 4 is formed of a workpiece holder fixing metal fitting 6, and a workpiece holder fixing spring 8. Workpiece holder fixing metal fitting 6 is provided with a mark for measurement 22 for measuring the position and rotating angle of rotating stage 16.

Provided on movement stage 12 are mirrors 10, 10 for measuring the position of Y-direction movement stage 2, and a rotating stage vibration stopper 24 for preventing rotating stage 16 from vibrating.

Note that measurement mark 22 described above is provided on a level with the drawing plane of workpiece 14, in order to measure the amount of movement (offset) of coordinates in the center of drawing and a rotating angle with an electron beam after rotating stage 16 is rotated.

Vibration stopper 24 fixes rotating stage 16 such that workpiece 14 will not vibrate during movement in the X or Y direction and drawing in progress after the rotation of rotating stage 16.

Note that in the above-described structure, a belt drive type rotating mechanism with drive motor 20 is used for rotating stage 16, but a direct drive type directly driven by a drive motor may be employed. The use of such structures can provide the workpiece with arbitrary rotating angles in response to patterns of exposure beams.

Fig. 4 a view showing a pattern P₁ with a rotating angle of α drawn on workpiece 14 with the electron beam drawing apparatus in the above embodiment, and Fig. 5 is a view showing pattern P₁ with rotating angle α formed according to a conventional technique.

Herein, in a drawing pattern having a rotating angle θ, as illustrated in Fig. 6, a perpendicular is drawn to a side defining the height (h) of a figure from the center of the figure (x, y), and the angle made between the perpendicular and the x-axis is referred to as rotating angle θ.

Now, steps included in a method of drawing with the above-described electron beam drawing apparatus will be described in conjunction with Figs. 7 and 8.

In step 10 (hereinafter referred simply to as S10), all angles for rectangles included in the entire drawing data are calculated, and the rectangles are divided into a group having a rotating angle 90°x n (n=0, 1, 2, 3, ...) (hereinafter referred to as rotating angle 90°x n) and the rest. Then in S20, the patterns having rotating angles other than rotating angles 90°x n are further divided into groups of patterns having identical rotating angles.

In S30, drawing data formed of an instruction of rotating the workpiece rotating stage and the basic parameters of a pattern (for a rectangle, central coordinates, width, and height) is produced. At the time, the amount of drawing data is smaller than conventional by the use of rotating angles, and the grouping of patterns by identical rotating angles can reduce overhead time associated with the rotation of the stage (time for stage rotation, time for measuring a measurement mark, etc).

In S40, workpiece 14 is mounted onto workpiece holder 4, and the position of measurement mark 22 on the rotating stage is measured by a laser interferometer 14 for maintaining the stage and by scanning with an electron beam. The measurement determines a coordinate origin and a coordinate axis for drawing.

In S50, rectangles with rotating angles 90°x n are drawn in a conventional manner. Then, in S60, the rotating stage is rotated clockwise by angle α in the case of drawing data with rotating angle α, for example.

In S70, measurement mark 22 on rotating stage 16 is measured in the same manner as in S40, and the amount of movement of the coordinate origin for drawing (offset amount) and the rotating angle are calculated. At the time, for a tolerance angular error of dθ, the process proceeds to the next step if the calculated rotating angle is within angle α°±dθ, and otherwise the rotating angle of the rotating stage is subjected to fine adjustment. In S80, a rectangle having rotating angle α is drawn in the same manner as the conventional variable formation method.

Note that if there are patterns having other rotating angles, the steps from S60 to S80 are repeatedly conducted until all the patterns are drawn. The use of such a method permits a large number of rotated patterns with arbitrary sizes and arbitrary angles to be readily and precisely drawn.

Fig. 8 is a representation showing how patterns included in a drawing pattern 48 are grouped. Patterns P_{A}, P_{B}, and P_{C} each have a rotating angle of 0°, patterns P_{D}, P_{E}, and P_{F} each have a rotating angle of α°, and patterns P_{G}, P_{H} and P_{I} are drawing patterns with a rotating angle of β°.

These patterns are first classified into a group G10 having rotating angle 90°x n, and a group G20 other than the patterns having rotating angle 90°x n. The drawing patterns included in group G20 are further classified into a group G40 having rotating angle of α° and a group G30 having rotating angle of β⁰.

The electron beam drawing apparatus of the above-described structure and a method of drawing with such an apparatus bring about the following effects.

### (1) High Speed Drawing

In terms of high speed drawing, when a memory device in which almost all figures involved are rectangles having rotating angles is drawn, time required for drawing thereof takes about 30 hours according to a conventional method with a conventional electron beam exposure apparatus, while according to the present invention, a plurality of rectangles having arbitrary rotating angles can be drawn by one shot, and therefore it takes only about several hours or shorter without limiting the rotating angles and sizes of rectangles at all.

### (2) Precision in Drawing

In view of the precision of figures drawn, according to a variable formation method only with a rectangular beam in which figures are approximated with such a rectangular beam, as illustrated in Figs. 18 and 19, the precision of a inclined side is particularly poor. If a rectangle as shown in Fig. 22 is drawn with a triangle beam formed with the second formation diaphragm as illustrated in Fig. 21, an edge roughness is produced at a joint of shots. In this embodiment, however, a rectangle having a rotating angle can be drawn with the same precision as the precision of drawing a rectangle having rotating angle 90°x n according to a conventional technique.

### (3) Flexibility with Respect to Rotating Angles and Sizes of Figures

According to the electron beam exposure apparatus in this embodiment, flexibility with respect to the sizes of figures and their rotating angles is high, basically with no limitation.

### (4) Amount of Drawing Data

The amount of drawing data for representing a rotated rectangle will be described in conjunction with Fig. 9.

According to a conventional method, a trapezoid (including a triangle) is represented by seven parameters, the center of the figure (x, y), two parameters (lW, rW) representing the slopes of the right and left inclined sides, and the kind of the figure (trapezoid).

If, for example, a 2-byte region is allocated as a drawing data amount to each of the seven parameters, the amount of drawing data necessary for representing one trapezoid will be 14 bytes. In a conventional method, a rotated rectangle or square must be represented by a plurality of trapezoids divided by lines parallel to x-axis or y-axis. For example, in order to represent a rotated square, at least two trapezoids (triangles) are necessary, and therefore at least 28 bytes will be necessary as a drawing data amount. In order to represent a rotated rectangle with trapezoids, and triangles, at least three trapezoids will be necessary, and therefore even a larger amount of drawing data will be necessary.

In this embodiment, however, only 12 bytes will be necessary in total as a drawing data amount, 10 bytes to represent one rectangle and 2 bytes to represent a rotating angle.

As illustrated in Fig. 10, if the information of rotating angles is as small as possible, the amount of drawing data is further reduced. In a memory device which is presently of interest, according to the method of representing shown in Fig. 10 wherein almost all the figure have identical rotating angles, the ratio of data related to the rotating angles in the entire data amount is almost negligibly small. Accordingly, in the present embodiment, the entire data amount can be reduced to at least 1/2 that required by the conventional method.

A second embodiment of the invention will be described in conjunction with Fig. 11.

In this embodiment, in order to provide an electron beam having an arbitrary rotating angle, an electron beam column 56 forming a rectangular beam is rotated, and the other structure is substantially identical to the conventional one shown in Figs. 13 and 14.

Electron beam column 56 is provided on a workpiece chamber 58 and covered with a column shield chamber 60 in order to keep electron beam column 56 in a vacuum.

Electron beam column 56 is formed to rotate by the driving force of driving motor 54 using a driving belt 52. Power supply rods 62, 64 are provided in order to supply power to driving motor 54.

With the above construction, precisely rotating and moving electron beam column 56 provides a rectangular electron beam having an arbitrary rotating angle.

With the above construction, the function and effects the same as those brought about by the electron beam drawing apparatus according to the first embodiment can be obtained.

A third embodiment of the invention will be described in conjunction with Fig. 12.

The electron beam drawing apparatus according to the third embodiment is configured to rotate a first formation diaphragm 66 and a second formation diaphragm 70 in the electron beam drawing apparatus, and the other construction is substantially identical to the conventional one shown in Figs. 13 and 14.

First formation diaphragm 66 and second formation diaphragm 70 are provided with motors 68 and 72, respectively in their peripheries, and rotating the motors rotates first formation diaphragm 66 and second formation diaphragm 70 by prescribed amounts and permits a rectangular beam having an arbitrary rotating angle to be formed.

In the third embodiment, the function and effects are the same as those brought about by the electron beam drawing apparatus according to the first embodiment.

According to the electron beam drawing apparatus according to the invention, the beam formation device and the workpiece installment device can be relatively moved in the direction of rotation along the drawing plane.

Thus, an arbitrary rotating angle can be made between the beam formation device and the workpiece installment device. As a result, a pattern having a rotating angle according to the above rotating angle can be readily and precisely drawn onto a workpiece by a single exposure.

Accordingly, time required for the manufacture of a semiconductor device can be reduced, and therefore manufactured semiconductor devices can be delivered earlier than conventional.

According to a method of drawing with an electron beam drawing apparatus according to one aspect of the invention, patterns having identical rotating angles are grouped, and patterns are drawn on a group basis.

Accordingly, time for making a prescribed rotating angle between the beam formation device and the workpiece installment device is reduced, thus reducing overhead time as well.

Thus, time required for the manufacture of semiconductor devices can be shorter than that required conventionally, and semiconductor devices can be provided to the market earlier.

In addition, according to a method of drawing with an electron beam drawing apparatus according to another aspect of the invention, after the first pattern is drawn, the workpiece installment device and beam formation device are relatively rotated by an angle corresponding to the difference between the first rotating angle and the second rotating angle.

Therefore, time required for making a prescribed rotating angle between the beam formation device and the workpiece installment device and the time for measuring the rotating angle are reduced, and so-called overhead time can be even smaller.

Although the present invention has been described and illustrated in detail, it is clearly understood that the same is by way of illustration and example only and is not to be taken by way of limitation, the scope of the present invention being limited only by the terms of the appended claims.

## Claims

1. An electron beam drawing apparatus, comprising:
an exposure beam generation device (118) for generating an exposure beam;
a beam formation device (162, 150, 152, 164; 56, 60) including a beam formation mask (140, 148, 200, 212; 66, 70) for forming said exposure beam into a prescribed shape; and
a workpiece installment device (2, 28, 46) for installing a workpiece (14) to be irradiated with said exposure beam and drawn with a prescribed pattern,
said workpiece installment device having a first stage (28) movable in a first direction (X) along a drawing plane of said workpiece (14) and a second stage (2) movable in a second direction (Y) perpendicular to said first direction (X),
characterized by
a rotating device (16; 52, 54; 68, 72) for relatively rotating said workpiece installment device and said beam formation mask (140, 148, 200, 212; 66, 70) so that said exposure beam having said prescribed shape and said workpiece (14) are rotatable relative to each other within said drawing plane.

2. The electron beam drawing apparatus as recited in claim 1, characterized in that
said rotating device is a third stage (16) of said workpiece installment device (2, 28, 46), said third stage (16) being rotatable within said drawing plane.

3. The electron beam drawing apparatus as recited in claim 2, wherein
said second stage (2) is provided on said first stage (28), and said third stage (16) is provided on said second stage (2).

4. The electron beam drawing apparatus as recited in claim 2 or 3, wherein
a rotating angle detection device (22) for detecting an rotating angle of said third stage (16) is provided at a prescribed position of said third stage (16).

5. The electron beam drawing apparatus as recited in claim 1, characterized in that
said rotating device (52, 54; 68, 72) rotates said beam formation mask (66, 70) within a plane parallel to said drawing plane.

6. A method of drawing with an electron beam drawing apparatus, said method comprising the steps of:
installing a workpiece (14) on a workpiece installment device (28, 2, 16, 46);
forming an exposure beam generated from an exposure beam generation device (118) into a prescribed shape with a beam formation device (162, 150, 152, 164; 56, 60) including a beam formation mask (140, 148, 200, 212; 66, 70);
characterized by :
relatively rotating said workpiece installment device (2, 28, 16, 46) and said beam formation mask (140, 148, 200, 212; 66, 70) such that said workpiece (14) is irradiated with the exposure beam formed into said prescribed shape rotated relatively to said workpiece (14), thereby drawing a pattern (P) having a prescribed angle on said workpiece (14).

7. The method as recited in claim 6, characterized in that in said step of drawing a pattern a plurality of patterns (P_{A} - P_{I}) having prescribed rotating angles (α; β) is drawn on said workpiece, whereby those patterns (P_{A}-P_{C} ; P_{D}-P_{F}; P_{G}-P_{I}) having identical rotating angles (0°, α; β) are grouped, and the patterns are drawn on a group basis. (Fig. 8)

8. The method as recited in claim 6 or 7, characterized in that
in said step of drawing a pattern a first pattern or a plurality of first patterns having a first rotating angle and a second pattern or a plurality of second patterns having a second rotating angle are drawn on said workpiece,
said step of drawing said first pattern or patterns and said second pattern or patterns including drawing said first pattern or patterns, then relatively rotating said workpiece installment device and said beam formation device by an angle corresponding to a difference between the first rotating angle and second rotating angle and drawing the second pattern or patterns. (Fig. 8)

## Patentansprüche

1. Elektronenstrahlzeichnungsvorrichtung, die aufweist:
eine Belichtunsstrahlerzeugungsvorrichtung (118) zum Erzeugen eines Belichtungsstrahles;
eine Strahlausbildungsvorrichtung (162, 150, 152, 164; 56, 60), die eine Strahlausbildungsmaske (140, 148, 200, 212; 66, 70) enthält, zum Ausbilden des Belichtungsstrahles in einer vorgeschriebenen Gestalt; und
eine Werkstückinstallierungsvorrichtung (2, 28, 46) zum Installieren eines Werkstückes (14), das mit dem Belichtungsstrahl zu bestrahlen und auf das ein vorgeschriebenes Muster zu zeichnen ist,
wobei die Werkstückinstallierungsvorrichtung eine erste Stufe (28), die in einer ersten Richtung (X) entlang einer Zeichenebene des Werkstückes (14) bewegbar ist, und eine zweite Stufe (2), die in einer zweiten Richtung (Y), die senkrecht zu der ersten Richtung (X) ist, bewegbar ist, aufweist,
gekennzeichnet durch
eine Drehvorrichtung (16, 52, 54; 68, 72) zum relativen Drehen der Werkstückinstallierungsvorrichtung und der Strahlausbildungsmaske (140, 148, 200, 212; 66, 70) derart, daß der Belichtungsstrahl, der die vorgeschriebene Gestalt aufweist, und das Werkstück (14) relativ zueinander in der Zeichenebene gedreht werden.

2. Elektronenstrahlzeichnungsvorrichtung nach Anspruch 1, dadurch gekennzeichnet, daß
die Drehvorrichtung eine dritte Stufe (16) der Werkstückinstallierungsvorrichtung (2, 28, 46) ist, wobei die dritte Stufe (16) in der Zeichenebene drehbar ist.

3. Elektronenstrahlzeichnungsvorrichtung nach Anspruch 2, bei der
die zweite Stufe (2) auf der ersten Stufe (28) vorgesehen ist, und
die dritte Stufe (16) auf der zweiten Stufe (2) vorgesehen ist.

4. Elektronenstrahlzeichnungsvorrichtung nach Anspruch 2 oder 3, bei der
eine Drehwinkeldetektionsvorrichtung (22) zum Detektieren eines Drehwinkels der dritten Stufe (16) an einer vorgeschriebenen Position der dritten Stufe (16) vorgesehen ist.

5. Elektronenstrahlzeichnungsvorrichtung nach Anspruch 1, dadurch gekennzeichnet, daß
die Drehvorrichtung (52, 54; 68, 72) die Strahlausbildungsmaske (66, 70) in einer Ebene, die parallel zu der Zeichenebene, liegt, dreht.

6. Verfahren zum Zeichnen mit einer Elektronenstrahlzeichnungsvorrichtung, wobei das Verfahren die Schritte aufweist:
Installieren eines Werkstückes (14) auf einer Werkstückinstallierungsvorrichtung (28, 2, 16, 46);
Ausbilden eines Belichtungsstrahles, der von einer Belichtungsstrahlerzeugungsvorrichtung (118) erzeugt wird, in eine vorgeschriebene Gestalt mit einer Strahlausbildungsvorrichtung (162, 150, 152, 164; 56, 60), die eine Strahlausbildungsmaske (140, 148, 200, 216; 66, 70) enthält;
relatives Drehen der Werkstückinstallierungsvorrichtung (2, 28, 16, 46) und der Strahlausbildungsmaske (140, 148, 200, 212; 66, 70) derart, daß das Werkstück (14) mit dem in die vorgeschriebene Gestalt ausgebildeten Belichtungsstrahl, der relativ zu dem Werkstück (14) gedreht ist, belichtet wird, wodurch ein Muster (P), das einen vorgeschriebenen Winkel aufweist, auf dem Werkstück (14) ausgebildet wird.

7. Verfahren nach Anspruch 6, dadurch gekennzeichnet, daß in dem Schritt des Zeichnens eines Musters eine Mehrzahl von Mustern (P_{A} - P_{I}), die vorgeschriebene Drehwinkel (α; β) aufweisen, auf das Werkstück gezeichnet wird, wodurch diese Muster (P_{A} - P_{C}; P_{D} - P_{F}; P_{G} - P_{I}), die identische Drehwinkel (0°; α; β) aufweisen, gruppiert werden, und die Muster auf einer Gruppenbasis gezeichnet werden. (Fig. 8)

8. Verfahren nach Anspruch 6 oder 7, dadurch gekennzeichnet, daß
in dem Schritt des Zeichnens eines Musters ein erstes Muster oder eine Mehrzahl von ersten Mustern, die einen ersten Drehwinkel aufweisen, und ein zweites Muster oder eine Mehrzahl von zweiten Mustern, die einen zweiten Drehwinkel aufweisen, auf das Werkstück gezeichnet werden,
wobei der Schritt des Zeichnens des ersten Musters oder der ersten Muster und des zweiten Musters oder der zweiten Muster das Zeichnen des ersten Musters oder der ersten Muster, dann das relative Drehen der Werkstückinstallierungsvorrichtung und der Strahlausbildungsvorrichtung um einen Winkel, der eine Differenz zwischen dem ersten Drehwinkel und dem zweiten Drehwinkel entspricht, und das Zeichnen des zweiten Musters oder der zweiten Muster enthält. (Fig. 8)

## Revendications

1. Appareil de traçage de motifs à faisceau d'électrons, comprenant :
un dispositif de génération de faisceau d'exposition (118), pour générer un faisceau d'exposition ;
un dispositif de formation de faisceau (162, 150, 152, 164; 56, 60), comportant un masque de formation de faisceau (140, 148, 200, 212 ; 66, 70), pour former ledit faisceau d'exposition selon une forme prescrite ; et
un dispositif d'installation de pièce de travail (2, 28, 46), pour installer une pièce de travail (14) destinée à être irradiée avec ledit faisceau d'exposition et dessinée avec un motif prescrit,
ledit dispositif d'installation de pièce de travail comportant un premier étage (28) mobile dans une première direction (X) le long d'un plan de dessin de ladite pièce de travail (14) et un deuxième étage (2) mobile dans une deuxième direction (Y) perpendiculaire à ladite première direction (X), caractérisé par
un dispositif rotatif (16; 52, 54; 68, 72), pour faire tourner de manière relative ledit dispositif d'installation de pièce de travail et ledit masque de formation de faisceau (140, 148, 200, 212; 66, 70) de façon que ledit faisceau d'exposition ayant ladite forme prescrite et ladite pièce de travail (14) puissent tourner l'un par rapport à l'autre à l'intérieur dudit plan de dessin.

2. Appareil de traçage de motifs à faisceau d'électrons selon la revendication 1, caractérisé en ce que
ledit dispositif rotatif est un troisième étage (16) dudit dispositif d'installation de pièce de travail (2, 28, 46), ledit troisième étage (16) étant rotatif à l'intérieur dudit plan de dessin.

3. Appareil de traçage de motifs à faisceau d'électrons selon la revendication 2, dans lequel
ledit deuxième étage (2) est disposé sur ledit premier étage (28) et ledit troisième étage (16) est disposé sur ledit deuxième étage (2).

4. Appareil de traçage de motifs à faisceau d'électrons selon la revendication 2 ou 3, dans lequel
un dispositif de détection d'angle de rotation (22), pour détecter l'angle de rotation dudit troisième étage (16) est prévu dans une position prescrite dudit troisième étage (16).

5. Appareil de traçage de motifs à faisceau d'électrons selon la revendication 1, caractérisé en ce que
ledit dispositif rotatif (52, 54; 68, 72) fait tourner ledit masque de formation de faisceau (66, 70) à l'intérieur d'un plan parallèle audit plan de dessin.

6. Procédé de traçage avec un appareil de traçage de motifs à faisceau d'électrons, ledit procédé comprenant les étapes consistant à :
installer une pièce de travail (14) sur un dispositif d'installation de pièce de travail (28, 2, 16; 46) ;
former un faisceau d'exposition généré à partir d'un dispositif de génération de faisceau d'exposition (118) selon une forme prescrite avec un dispositif de formation de faisceau (162, 150, 152, 164; 56, 60) comportant un masque de formation de faisceau (140, 148, 200, 212; 66, 70) ;
caractérisé par :
la rotation relative dudit dispositif d'installation de pièce de travail (2, 28, 16; 46) et dudit masque de formation de faisceau (140, 148, 200, 212; 66, 70), de façon que ladite pièce de travail (14) soit irradiée par le faisceau d'exposition formé selon ladite forme prescrite, tourné par rapport à ladite pièce de travail (14), dessinant ainsi un motif (P) ayant un angle prescrit sur ladite pièce de travail (14).

7. Procédé selon la revendication 6, caractérisé en ce que, dans ladite étape de dessin d'un motif, une pluralité de motifs (P_{A} - P_{I}) ayant des angles de rotation prescrits (α ; β) sont dessinés sur ladite pièce de travail, de façon que ceux parmi les motifs (P_{A}-P_{C}; P_{D}-P_{F}; P_{G}-P_{I}) qui ont des angles de rotation (0°, α; β) identiques soient regroupés, et que les motifs soient dessinés sur une base de groupe (figure 8).

8. Procédé selon la revendication 6, caractérisé en ce que dans ladite étape de dessin d'un motif, un premier motif ou une pluralité de premiers motifs ayant un premier angle de rotation et un deuxième motif ou une pluralité de deuxièmes motifs ayant un deuxième angle de rotation sont dessinés sur ladite pièce de travail,
ladite étape de dessin dudit premier motif ou desdits premiers motifs et dudit deuxième motif ou desdits deuxièmes motifs comportant le dessin dudit premier motif ou desdits premiers motifs, puis la rotation relative dudit dispositif d'installation de pièce de travail et dudit dispositif de formation de faisceau selon un angle correspondant à la différence entre le premier angle de rotation et le deuxième angle de rotation et le dessin du deuxième motif ou des deuxièmes motifs (figure 8).
